(19) **Europäisches Patentamt / European Patent Office / Office européen des brevets**

(11) **EP 3 707 528 B1**

(12) **FASCICULE DE BREVET EUROPEEN**

(45) Date de publication et mention de la délivrance du brevet:
**23.11.2022 Bulletin 2022/47**

(21) Numéro de dépôt: **18762325.1**

(22) Date de dépôt: **07.09.2018**

(51) Classification Internationale des Brevets (IPC):
**G01S 17/08** (2006.01)   **G01S 7/40** (2006.01)
**H01Q 3/26** (2006.01)   **G01R 29/10** (2006.01)
**H01Q 3/46** (2006.01)   **H01Q 21/06** (2006.01)
**G01S 7/02** (2006.01)

(52) Classification Coopérative des Brevets (CPC):
**G01S 17/08; G01S 7/021; H01Q 3/2676;**
G01R 29/10; G01S 7/4082

(86) Numéro de dépôt international:
**PCT/EP2018/074106**

(87) Numéro de publication internationale:
**WO 2019/091624 (16.05.2019 Gazette 2019/20)**

(54) **DISPOSITIF DE STIMULATION RADIOELECTRIQUE PAR PANNEAU RAYONNANT**

STRAHLUNGSFELDFUNKSTIMULATIONSVORRICHTUNG

RADIANT-PANEL RADIO STIMULATION DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **07.11.2017 FR 1701140**

(43) Date de publication de la demande:
**16.09.2020 Bulletin 2020/38**

(73) Titulaire: **Thales**
**92400 Courbevoie (FR)**

(72) Inventeurs:
• **MAZEAU, Thierry**
  **33700 Merignac (FR)**
• **JAHAN, Daniel**
  **29238 Brest Cedex 3 (FR)**
• **FORMONT, Stéphane**
  **78851 Elancourt (FR)**
• **MENAGER, Loïc**
  **78851 Elancourt (FR)**

(74) Mandataire: **Atout PI Laplace**
**Immeuble "Visium"**
**22, avenue Aristide Briand**
**94117 Arcueil Cedex (FR)**

(56) Documents cités:
**WO-A1-2015/028091      FR-A1- 2 695 759**

• **MODESTO E GODINEZ ET AL: "RF Characterization of Zero-Biased Photodiodes", JOURNAL OF LIGHTWAVE TECHNOLOGY, IEEE SERVICE CENTER, NEW YORK, NY, US, vol. 26, no. 24, 15 décembre 2008 (2008-12-15), pages 3829-3834, XP011241689, ISSN: 0733-8724, DOI: 10.1109/JLT.2008.927794**
• **MARK DORSEY W ET AL: "Design and Performance of Frequency Selective Surface With Integrated Photodiodes for Photonic Calibration of Phased Array Antennas", IEEE TRANSACTIONS ON ANTENNAS AND PROPAGATION, IEEE SERVICE CENTER, PISCATAWAY, NJ, US, vol. 58, no. 8, 1 août 2010 (2010-08-01), pages 2588-2593, XP011309298, ISSN: 0018-926X**
• **PAEK E G ET AL: "Photonic In-Situ Calibration of a Phased Array Antenna Using Planar Lightwave Circuit", MICROWAVE PHOTONICS, 2005. MWP 2005. INTERNATIONAL TOPICAL MEETING ON SEOUL, KOREA 12-14 OCT. 2005, PISCATAWAY, NJ, USA,IEEE, 12 octobre 2005 (2005-10-12), pages 351-354, XP010890701, ISBN: 978-89-950043-3-3**

EP 3 707 528 B1

• LEVINE E ET AL: "Fiber optic networks for phased arrays", ELECTRICAL AND ELECTRONICS ENGINEERS IN ISRAEL, 1991. PROCEEDINGS., 17 TH CONVENTION OF TEL AVIV, ISRAEL 5-7 MARCH 1, NEW YORK, NY, USA,IEEE, US, 5 mars 1991 (1991-03-05), pages 390-393, XP010041253, DOI: 10.1109/EEIS.1991.217685 ISBN: 978-0-87942-678-1

**Description**

L'invention se rapporte au domaine technique général des antennes à formation de faisceaux, en particulier celles réalisées en état-solide.

L'invention se rapporte plus particulièrement au test et à la stimulation de systèmes de réception radioélectrique comme par exemple les détecteurs de radars ou les intercepteurs de communications, en particulier lorsque ceux-ci sont installés sur leur plate-forme porteuse. *CONTEXTE DE L'INVENTION - ART ANTERIEUR*

Pour stimuler un système de réception radioélectrique, une fois installé sur sa plate-forme porteuse, sans y apporter de modification, une possibilité est d'utiliser un dispositif de stimulation tel que celui décrit dans la demande de brevet français FR1700081 déposée le 26 janvier 2017.

Un tel dispositif, qui permet d'illuminer un aérien avec une onde radioélectrique portant une loi de phase donnée, comporte une pluralité d'antennes élémentaires réparties. Il comporte également un module émetteur distant de l'aérien sous test et un module récepteur placé au voisinage de la surface rayonnante de ce dernier. Le module émetteur génère un signal résultant de la combinaison d'une pluralité de signaux porteurs à des fréquences porteuses différentes, chacun étant modulé par un signal de modulation spécifique. Il transmet en outre ce signal au module récepteur qui comporte une pluralité de récepteurs élémentaires associés chacun à un élément rayonnant. Chaque récepteur élémentaire réalise la démodulation d'un des signaux porteurs modulés reçu par le module récepteur, et rayonne le signal démodulé vers la surface de l'aérien sous test. Par ailleurs, chaque récepteur élémentaire est agencé sur le module récepteur de telle façon que son élément rayonnant se trouve placé en regard d'une des antennes constituant le système de réception radioélectrique sous test et que le signal radioélectrique qu'il émet soit capté majoritairement par cette antenne.

Cette solution implique toutefois l'emploi de dispositifs matériels, les récepteurs élémentaires en particulier, qui doivent être plaqués sur les aériens dudit système de réception radioélectrique sous test.

Par suite, sans pour autant être considérée comme intrusive une telle solution a des incidences pratiques. En particulier elle limite l'accessibilité aux aériens du système testé. Par ailleurs elle présente également des limites induites par les performances de couplage des antennes d'un module récepteur du dispositif de test avec celles de l'aérien du système sous test auquel il est associé.

Pour stimuler un système de réception radioélectrique, une fois installé sur sa plate-forme porteuse, sans y apporter de modification, on peut également, de manière connue, recourir à une génération classique d'un signal radioélectrique et à l'émission à distance de ce signal vers le système de réception radioélectrique à tester. La distance impose cependant de disposer d'un certain niveau de puissance rayonnée en direction dudit système de réception radioélectrique.

Cette contrainte conduit à envisager des solutions présentant des structures similaires à celles des émetteurs opérationnels, les systèmes de réception radioélectrique dont on veut réaliser le test étant, par principe adaptés pour recevoir les signaux de tels émetteurs.

Les dispositifs correspondants présentent des architectures semblables aux architectures radar, limitées cependant à la fonction émission et, en particulier, des architectures semblables à celles des radars à balayage électronique qui présentent l'intérêt de ne pas faire intervenir de moyens mécanique pour assurer le pointage du faisceau d'antenne dans la direction voulue.

Ces architectures sont généralement compactes, l'émetteur ainsi réalisé étant un élément monobloc. Or pour les applications visées, à savoir des applications de test non intrusives, il existe un besoin de désolidariser le sous-ensemble générant le signal de test du sous-ensemble rayonnant ce dernier, tout en simplifiant au maximum la structure du sous-ensemble rayonnant car cette dernière peut être multipliée.

Par suite, le problème technique qui se pose, en présence d'un sous-ensemble de génération et d'un sous-ensemble rayonnant disjoints, voire distants, l'un de l'autre consiste à trouver une solution permettant de transmettre vers le second sous-ensemble le signal de stimulation généré par le premier sous-ensemble, sans altération de la loi de phase portée par ce signal.

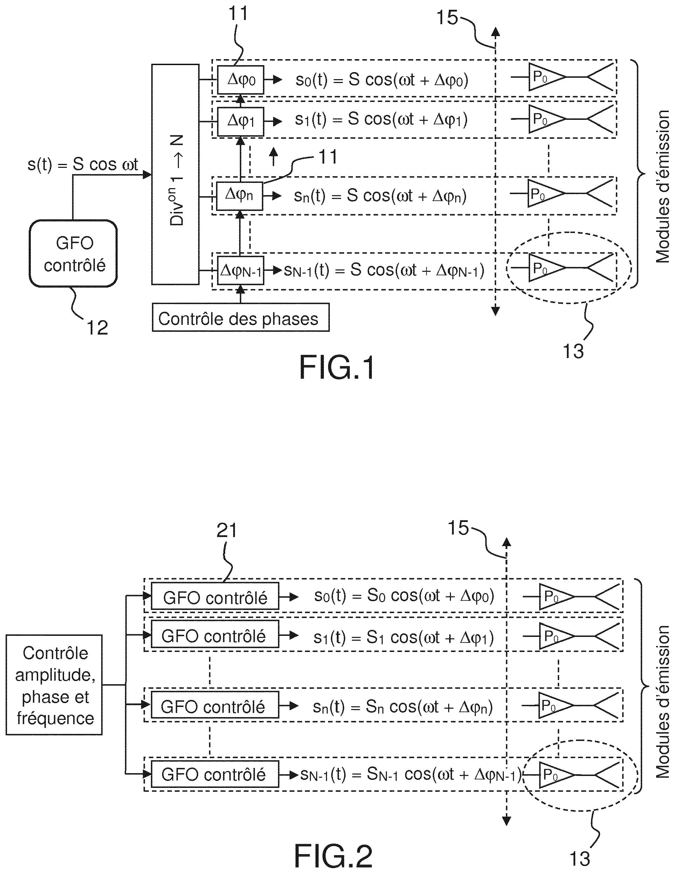

Les dispositifs de test de l'état de l'art ne permettent généralement pas de répondre à ce problème, dans la mesure où ce sont généralement des dispositifs compacts dont la structure correspond aux schémas de principe des figures 1 et 2.

La figure 1 présente une structure de dispositif dans laquelle la loi de phase est réalisée par des déphaseurs contrôlés 11 (structure classique) placés en sortie d'un générateur de forme d'onde (GFO) 12, contrôlé en amplitude et en fréquence, chaque déphaseur délivrant un signal porteur d'une phase donnée à un module d'émission 13.

La figure 2 présente une structure de dispositif dans laquelle la loi de phase est réalisée par synthèse directe par des générateurs de formes d'onde 21 contrôlés également par une commande 22 d'amplitude, de fréquence et de phase (structure MIMO ou *Multiple Inputs Multiple Outputs* selon la dénomination anglo-saxonne).

Une solution au problème posé consiste à réaliser une séparation physique entre les modules d'émission et les modules de génération de signaux au niveau de la sortie des signaux déphasés, juste avant l'amplification de puissance, comme illustré par les lignes pointillées 15 des figures 1 et 2.

Cette coupure conduit à regrouper matériellement ce qui réalise l'ensemble des signaux déphasés, que ce soit une solution à déphaseurs illustrée par la figure 1 ou une solution par générateurs de forme d'onde (GFO) illustrée par la figure 2, et à regrouper matériellement les fonctions d'amplification en puissance et de rayonnement en un sous-ensemble dit d'émission et les fonction de synthèse des signaux d'excitation en un sous-ensemble dit de génération de signaux.

Le problème technique initialement posé consiste donc alors, dans un tel cas à trouver un moyen permettant de réaliser l'acheminement des signaux hyperfréquence, porteurs de la loi de phase, produits par des moyens de génération, des signaux pouvant atteindre plusieurs dizaines de GHz, vers les moyens d'amplification et de rayonnement qui peuvent être distants des premiers de plusieurs mètres, voire de plusieurs dizaines de mètres.

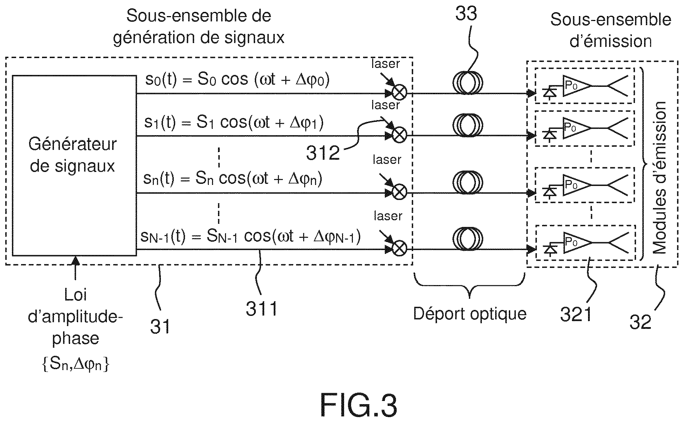

De manière connue, la transmission des signaux électriques du sous-ensemble de génération de signaux 31 vers le sous-ensemble d'émission 32 de ces signaux peut être réalisée au moyen d'un déport par fibre optique 33 comme dans le cas du dispositif illustré par la figure 3. Chaque signal électrique 311 issu du générateur de forme d'onde est alors porté par une onde lumineuse 312 de longueur d'onde dédiée.

Par ailleurs, chaque onde lumineuse 312 peut être transmise de manière séparée au module correspondant 321 du sous-ensemble émetteur par une fibre optique 33 dédiée, comme illustré plus particulièrement par la figure 3. Alternativement les différentes ondes lumineuses peuvent être multiplexées et transmises de manière groupée sur une ou plusieurs fibres optiques.

Ce mode de transmission, qui permet d'assurer une transmission sans altération sensible des signaux électriques du sous-ensemble de génération de signaux vers le sous-ensemble d'émission, présente néanmoins l'inconvénient de maintenir un lien physique, quoique lâche, entre les deux sous-ensembles, ce qui peut constituer une difficulté pour certaines applications.

Alternativement, manière connue également, la transmission des signaux électriques du sous-ensemble de génération de signaux vers le sous-ensemble d'émission de ces signaux peut être réalisée, sans support matériel, au moyen d'un faisceau radioélectrique ou d'un faisceau laser comme l'explique la demande de brevet français FR1700081 cité précédemment. La figure 4 présente de manière schématique un exemple de structure de dispositif de test, formée de deux sous-ensembles disjoints l'un de l'autre et dans laquelle la transmission des signaux électrique est réalisée au moyen d'un faisceau laser composite pointé.

Ce mode de transmission, présente pour avantage de supprimer tout lien physique entre les deux sous-ensembles. En revanche, il présente pour inconvénient de conduire à une altération de la loi de phase formée par les signaux reçus par le sous-ensemble d'émission, altération consécutive principalement à la direction d'arrivée du faisceau laser composite reçue par rapport au sous-ensemble d'émission et à la distance entre le sous ensemble de génération de signaux et le sous-ensemble d'émission.

Par suite, du fait de l'altération de la loi de phase, le faisceau radioélectrique émis par le sous-ensemble d'émission présente, par rapport à sa direction de référence qui correspond à une distribution équiphase, une déflexion différente de la déflexion correspondant à la loi de phase désirée, portée par les signaux électriques générés par le générateur de forme d'onde.

Cette altération peut dans certains cas être suffisante pour dégrader de manière significative le fonctionnement du dispositif de test, de sorte qu'il y a lieu de trouver un moyen pour en annuler ou du moins en diminuer sensiblement les effets.

Un document WO 2015/028091 divulgue un générateur de signal pour une antenne à balayage électronique.

*PRESENTATION DE L'INVENTION*

Compte tenu du contexte évoqué précédemment, un but de l'invention est de proposer une solution permettant de compenser les effets de l'orientation du faisceau laser composite par rapport au sous-ensemble d'émission, ainsi que la distance séparant les deux sous-ensembles, sur la sur l'orientation du faisceau radioélectrique émis par le sous-ensemble d'émission, autrement dit sur la loi de phase appliquée aux éléments rayonnants constituant le sous-ensemble d'émission.

A cet effet l'invention a pour objet un dispositif de stimulation radioélectrique par panneau rayonnant, pour émettre un signal de test vers une antenne de réception.

Ledit dispositif comporte un sous-ensemble générateur de signaux électriques d'excitation présentant chacun une phase correspondant à une loi de phase souhaitée $\{\Delta\varphi_n\}$ et au moins un sous-ensemble d'émission configuré pour amplifier et rayonner lesdits signaux électriques de façon à émettre un faisceau radioélectrique dans une direction déterminée par ladite loi de phase $\{\Delta\varphi_n\}$.

Les signaux électriques sont transmis par le sous-ensemble générateur vers le sous-ensemble d'émission sous forme d'ondes laser modulées par lesdits signaux et formant un faisceau laser composite dirigé vers la surface d'un ensemble de photodétecteurs intégré au sous-ensemble d'émission.

Selon l'invention, le sous-ensemble générateur de signaux électriques et le sous-ensemble d'émission sont agencés l'un vis-à-vis de l'autre de telle façon que le faisceau laser composite soit dirigé vers la surface de l'ensemble de photodétecteurs sous une incidence ($\alpha$, $\beta$) par rapport à un axe de référence et qu'il parcourt une distance $D$ entre son point d'émission $M$ et un point de référence $O$ situé sur l'axe de référence au niveau de la surface de l'ensemble de photodétecteurs.

Le dispositif comporte en outre un système de correction configuré pour mesurer les valeurs $\alpha$, $\beta$ et $D$ et délivrer une loi de phase corrigée $\{\Delta\varphi'_n\}$ venant se substituer à la loi de phase voulue $\{\Delta\varphi_n\}$, la loi de phase corrigée étant définie de telle façon que le faisceau radioélectrique produit à partir des signaux générés par le module générateur de signaux soit orienté dans la direction correspondant à la loi de phase voulue $\{\Delta\varphi_n\}$.

La loi de phase corrigée $\Delta\varphi'_n$ est déterminée à partir du calcul de la différence de marche $\delta_n = D'_n - D$ engendrée, au niveau de chacun des photodétecteurs, par l'angle d'incidence du faisceau laser composite sur la surface de l'ensemble de photodétecteurs du sous-ensemble d'émission, $\Delta\varphi'_n$ étant défini par la relation :

$$\Delta\varphi'_n = \Delta\varphi_n - 2\pi\frac{f_s}{c}\cdot\delta_n \; ;$$

où $D'_n$ représentant la distance entre le point d'émission $M$ du faisceau laser composite et la position $P_n$ du photodétecteur considéré.

Selon une disposition particulière, les photodétecteurs qui forment l'ensemble de photodétecteurs du sous-ensemble d'émission sont agencés dans un plan (*xOz*) sur lequel leurs positions $P_n$ sont repérées, en cordonnées polaires, par une distance $d'_n$ et un angle $\gamma'_n$.

La différence de marche $\delta_n$ est alors définie, pour chaque photodétecteur, par la relation suivante :

$$\delta_n = D'_n - D$$
$$= D\cdot\left(\sqrt{1 - 2(\cos\gamma'_n\cos\beta\cos\alpha + \sin\gamma'_n\sin\beta)\left(\frac{d'_n}{D}\right) + \left(\frac{d'_n}{D}\right)^2} - 1\right).$$

Selon une autre disposition, les valeurs $\alpha$, $\beta$ et $D$ sont déterminées en considérant une pluralité de points $C_n$, non alignés, situés à la surface de l'ensemble de photodétecteurs, et en déterminant la distance $D_n$ séparant le point $M$ d'émission du faisceau laser composite de chacun des points $C_n$ considérés.

Selon une autre disposition, les valeurs $\alpha$, $\beta$ et $D$ sont déterminées en considérant au moins trois points non alignés.

Selon une autre disposition, les points $C_n$ étant repérés dans le plan (*xOz*) par leur distance $d_n$ au point de référence $O$ et par l'angle $\gamma_n$ entre l'axe reliant le point $C_n$ considéré au point $O$ et l'axe de référence (*Ox*), $D$, $\alpha$ et $\beta$ sont donnés par les relations suivantes :

$$D = \sqrt{\frac{d_2 d_3 (D_1^2 - d_1^2)[\cos\gamma_2\sin(\gamma_1-\gamma_3) - \cos\gamma_3\sin(\gamma_1-\gamma_2)]}{d_3(d_2\cos\gamma_2 - d_1\cos\gamma_1)\sin(\gamma_1-\gamma_3) - d_2(d_3\cos\gamma_3 - d_1\cos\gamma_1)\sin(\gamma_1-\gamma_2)} + }$$
$$\frac{d_1\cos\gamma_1[d_2(D_3^2 - d_3^2)\sin(\gamma_1-\gamma_2) - d_3(D_2^2 - d_2^2)\sin(\gamma_1-\gamma_3)]}{d_3(d_2\cos\gamma_2 - d_1\cos\gamma_1)\sin(\gamma_1-\gamma_3) - d_2(d_3\cos\gamma_3 - d_1\cos\gamma_1)\sin(\gamma_1-\gamma_2)} \; ;$$

$$\beta = \text{Arcsin}\frac{(d_1^2 + D^2 - D_1^2)d_2\cos\gamma_2 - (d_2^2 + D^2 - D_2^2)d_1\cos\gamma_1}{2d_1 d_2 D\sin(\gamma_1-\gamma_2)}$$

et

$$\alpha = \text{Arccos} \frac{\frac{d_1{}^2 + D^2 - D_1{}^2}{2d_1 D} - \sin\gamma_1 \sin\beta}{\cos\gamma_1 \cos\beta}.$$

Selon une autre disposition, les distances $D_n$ sont mesurées par télémétrie laser.

Selon une autre disposition, les distances $D_n$ sont mesurées en utilisant le faisceau laser composite produit par le sous-ensemble générateur de signaux.

Selon une autre disposition, l'ensemble de photodétecteurs est constitué par une matrice de photodiodes associées chacune à un filtre optique configuré pour ne permettre l'exposition de la photodiode considérée qu'à une des ondes laser modulées formant le faisceau laser composite.

Les caractéristiques techniques présentées par le dispositif selon l'invention conformément aux diverses dispositions listées précédemment peuvent dans le cadre de l'invention être considérée séparément les unes des autres ou bien en diverses combinaisons.

Selon une forme de mise en œuvre particulière, le dispositif selon l'invention comporte un sous-ensemble générateur de signaux électriques et au moins deux sous-ensembles d'émission, l'optique pointée étant configurée pour diriger le faisceau laser composite alternativement sur l'un ou l'autre des sous-ensembles d'émission, le système de correction de la loi de phase étant configuré pour délivrer à chaque moment la loi de phase corrigée $\{\Delta\varphi'_n\}$ correspondant au sous-ensemble sur lequel le faisceau laser composite est dirigé à l'instant considéré.

Les caractéristiques et avantages de l'invention seront mieux appréciés grâce à la description qui suit, description qui s'appuie sur les figures annexées qui présentent :

la figure 1, une illustration schématique de la structure d'un premier type de dispositif de stimulation radioélectrique par panneau rayonnant connu de l'art antérieur ;

la figure 2, une illustration schématique de la structure d'un deuxième type de dispositif de stimulation radioélectrique par panneau rayonnant connu de l'art antérieur ;

la figure 3, une illustration schématique de la structure d'un troisième type de dispositif de stimulation radioélectrique par panneau rayonnant connu de l'art antérieur ;

la figure 4, une illustration schématique de la structure d'un exemple de réalisation du dispositif de stimulation radioélectrique par panneau rayonnant selon l'invention;

les figures 5 à 7, des illustrations permettant de mettre en évidence le problème technique posé dans le cadre de l'invention et la nature de la solution apportée par l'invention ;

la figure 8, une illustration schématique de la structure d'un mode de mise en œuvre particulier du dispositif selon l'invention.

Il est à noter que, pour les figures annexées, un même élément fonctionnel ou structurel porte de préférence un même symbole repère. *DESCRIPTION DETAILLEE*

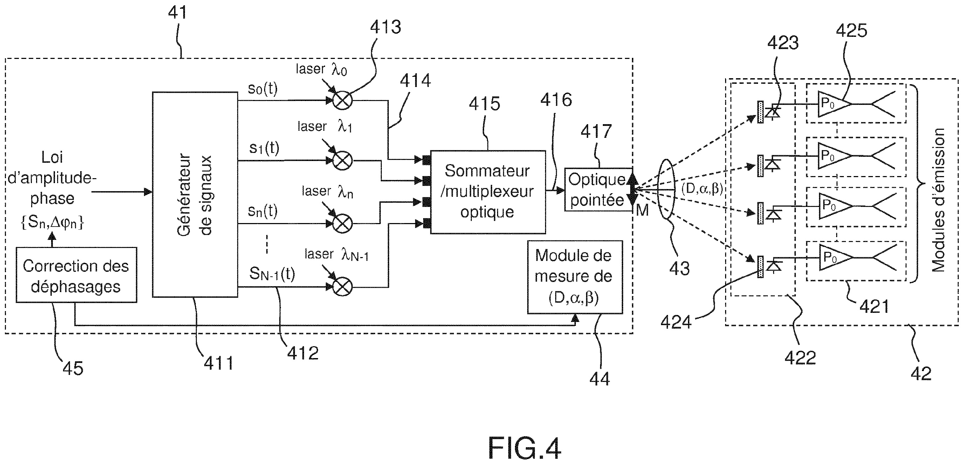

La figure 4 présente de manière schématique, à titre d'exemple non limitatif, la structure d'un dispositif de stimulation radioélectrique par panneau rayonnant mettant en œuvre l'invention.

Un tel dispositif comprend deux sous-ensembles physiquement séparées :

- un premier sous-ensemble 41 comportant un générateur de signaux électriques 411 produisant des signaux électriques 412 déphasés les uns par rapport aux autres conformément à une loi de phase donnée, la loi de phase appliquée correspondant à la direction dans laquelle on souhaite orienter l'émission du signal radioélectrique de test ;
- un second sous-ensemble d'émission 42 comportant panneau rayonnant à formation de faisceau, constitué d'un certain nombre de modules d'émission 421 configurés pour rayonner, chacun, un des signaux électriques générés.

Le sous-ensemble 41 comporte en outre des moyens 413, 414 et 415 permettant de réaliser la transmission des signaux électrique 412, sur une porteuse optique 43 modulée par lesdits signaux, vers le sous-ensemble 42.

Le sous-ensemble 42 comporte, quant à lui, un ensemble de moyens 422 pour réaliser la réception du faisceau laser composite 43 et sa démodulation, de façon à restituer les signaux électriques portés par l'onde lumineuse.

Le premier sous-ensemble 41 comporte ainsi principalement, de manière classique :

- un générateur de signaux électriques 411 produisant $N$ signaux électriques 412 : $s_0(t) = S_0 \cos(\omega t + \Delta\varphi_0)$, $s_1(t) = S_1 \cos(\omega t + \Delta\varphi_1)$,..., $s_{N-1}(t) = S_{N-1} \cos(\omega t + \Delta\varphi_{N-1})$, la structure dudit générateur de signaux pouvant être analogue, par exemple, à l'une ou l'autre de celles illustrées par les figures 1 ou 2 ;

- $N$ sources laser de longueurs d'onde distinctes $\lambda_0$, $\lambda_1$,..., $\lambda_{N-1}$ ;

- $N$ modulateurs optiques 413, chaque modulateur optique permettant la modulation d'amplitude d'une source laser de longueur d'onde $\lambda_n$ par un signal électrique d'entrée $S_n \cos(\omega t + \Delta\varphi_n)$ ;

- un multiplexeur 415 permettant de sommer les $N$ signaux lasers modulés 414 produits, porteurs de la loi d'amplitude-phase, et former un signal laser composite 416 ;

- une optique pointée 417, pour rayonner correctement le signal laser composite 416, c'est-à-dire former un faisceau laser composite 43, le diriger et le focaliser correctement pour illuminer complètement les moyens 422 de réception des ondes lumineuses du sous-ensemble d'émission 42. Dans l'exemple de la figure 4, les moyens 422 sont constitués par une matrice plane de photodiodes 423 ;

- des circuits d'alimentation en énergie électrique et de servitude, non représentés en figure 4.

Selon l'invention, le premier sous-ensemble 41, comporte en outre un système de correction de la loi de phase appliquée au générateur de signaux 411, système comportant lui-même :

- un module de mesure 44 permettant de déterminer les grandeurs $D$, $\alpha$ et $\beta$. $D$ représente la distance entre l'optique pointée 417 et la matrice de photodiodes 422, et ($\alpha$, $\beta$) l'orientation angulaire de l'axe du faisceau laser composite 43 par à une direction de référence définie pour la matrice de photodiodes 422 ;

- un module de correction 45 dont le rôle est de calculer une loi de commande amplitude-phase corrigée, destinée à être appliquée au générateur de signaux 411, loi qui est fonction des mesures des grandeurs $D$, $\alpha$ et $\beta$ réalisées par le module de mesure 44.

Le principe de fonctionnement de ce dispositif de correction est présenté dans la suite du texte.
Le sous-ensemble d'émission 42, comporte quant à lui :

- Une matrice 422 de $N$ photodiodes 423, chaque photodiode étant équipée d'un filtre optique 424 centré sur une longueur d'onde $\lambda_n$, laissant passer cette longueur d'onde et ne laissant pas passer les autres longueurs d'onde $\lambda_{n' \neq n}$ constituant le faisceau laser composite 43 ;

- $N$ amplificateurs de puissance 425, chaque amplificateur de puissance recevant le signal électrique venant d'une photodiode 423 ;

- $N$ antennes 426 disposées en réseau pour former un faisceau à la fréquence $f = \dfrac{\omega}{2\pi}$ des signaux électriques élaborés par le générateur de signaux électriques 411, chaque antenne 426 étant alimentée par la sortie d'un amplificateur de puissance 425 ;

- des circuits d'alimentation en énergie électrique et de servitude, non représentés sur la figure 4.

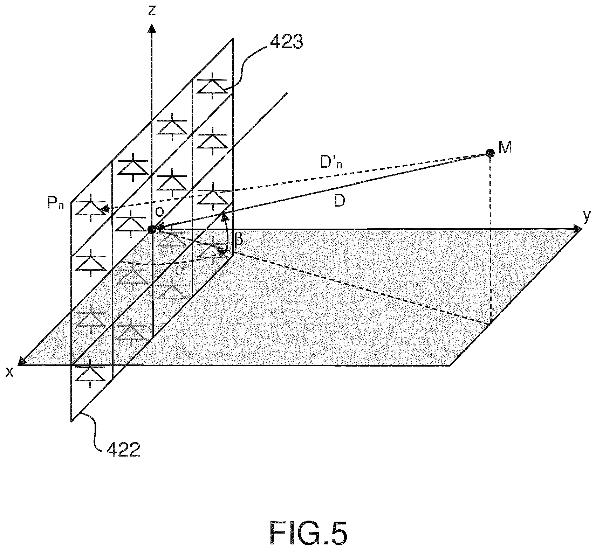

Les figures 5 à 7 illustrent le principe de fonctionnement du dispositif de correction qui équipe le dispositif de stimulation radioélectrique par panneau rayonnant selon l'invention.
Dans le cadre des figures 5 à 7, pour des raisons de simplification de l'illustration, la matrice de photodiodes 423 est représentée sous la forme d'une structure plane sur laquelle les photodiodes sont réparties de manière régulière en rangées et colonnes.
Cette disposition, qui facilite la compréhension de l'invention est utilisée dans la suite du texte pour en décrire le principe de fonctionnement. Elle ne doit cependant pas être considérée comme une caractéristique limitative, tout autre arrangement de photodiodes permettant de capter l'ensemble de composantes du faisceau laser composite 43 pouvant être mise en œuvre dans le cadre de l'invention.
Il est à noter cependant que, d'un point de vue matériel, la matrice de photodiodes 422 possède par principe une certaine taille, due au fait qu'il est nécessaire d'espacer les photodiodes 423 pour qu'elles puissent être illuminées de manière adéquate par le faisceau laser composite 43.

Comme le montre la figure 5, le trajet $D'_n$ du faisceau laser composite depuis le point *M* au départ de l'optique pointée 417 jusqu'à une photodiode donnée située au point $P_n$ du plan (*xOz*) de la matrice 422 dépend d'une distance de référence *D* du point *M* à un point *O* de la matrice de photodiodes pris comme référence, le centre de la matrice par exemple, et de l'orientation angulaire spatiale (*α, β*) de la direction de référence *OM* par rapport à une direction de référence de la matrice de photodiodes 422, l'axe (*Ox*) par exemple.

Compte tenu du positionnement relatif des sous-ensembles 41 et 42 constituant le dispositif selon l'invention, les trajets $D'_n$ aboutissant à l'ensemble des photodiodes possèdent des longueurs qui ne sont pas rigoureusement identiques.

Ces différences de longueur sont dues, au premier ordre, à l'orientation angulaire spatiale (*α, β*) du faisceau laser composite 43, et, au second ordre, à la distance *D* qui peut ne pas être suffisamment grande par rapport à la taille de la matrice de photodiodes pour que sa contribution aux différences de longueurs des trajets $D'_n$ puisse être négligée.

Ces différences de longueur des trajets $D'_n$ se traduisent par des différences de marche $\delta_n = D'_n - D$ de valeurs différentes pour chaque photodiode 423. Elles occasionnent un retard des signaux lasers modulés qui varie d'une photodiode à l'autre en fonction de la position de la photodiode considérée dans la matrice 422.

Par suite, elles induisent des déphasages $\Delta\phi_{n[deg]} = 1{,}2f_{[GHz]} \cdot \delta_{n[mm]}$ sur les signaux électriques détectés par la matrice de photodiodes 422 qui s'ajoutent finalement pour chaque signal à la phase correspondant à la loi de phase créée à l'origine et émise par l'optique pointée 417.

Il est à noter qu'une simple application numérique permet de constater que ces déphasages parasites ne sont pas négligeables.

Ainsi, par exemple, pour un signal électrique, de fréquence 10*GHz,* porté par le faisceau laser 43, une différence de marche de 10mm crée un déphasage de 120°.

Par suite, pour obtenir la loi de phase souhaitée $\{\Delta\varphi_n\}$, le module de correction 45 selon l'invention a pour fonction d'élaborer la loi de phase $\{\Delta\phi_n\}$ induite par les différences de marche $\delta_n = D'_n - D$, à partir des mesures de *D, α* et *β* fournies par le module de mesure 44 et de déterminer la loi de phase $\{\Delta\varphi'_n\}$, égale à $\{\Delta\varphi_n - \Delta\phi_n\}$, à générer au niveau du générateur 411.

De manière générale, la loi de phase corrigée $\{\Delta\varphi'_n\}$, est donnée par la relation :

$$\Delta\varphi'_n = \Delta\varphi_n - 2\pi\frac{f_s}{c}\cdot\delta_n \qquad\qquad [001]$$

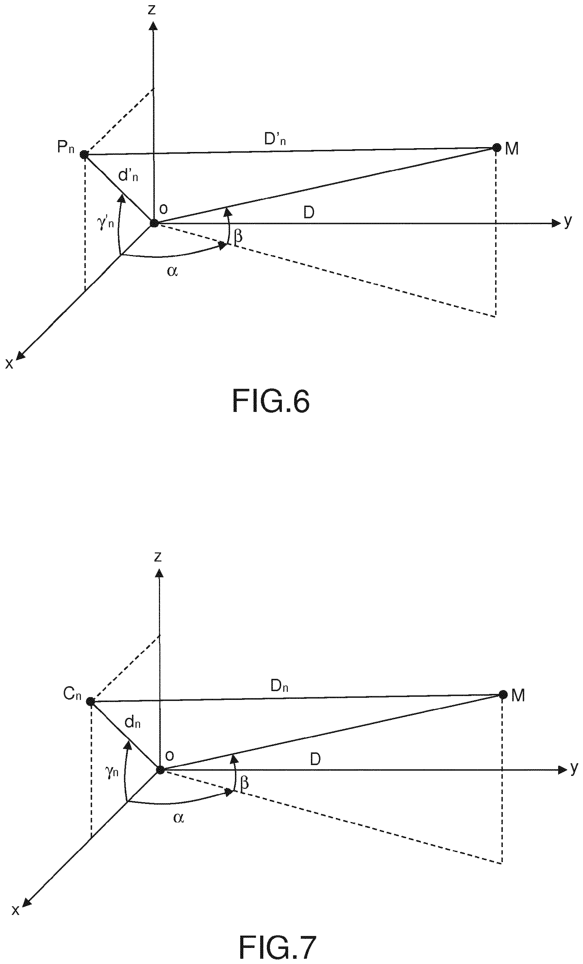

Dans le cas particulier illustré par les figures 5 à 7, les photodiodes chargées de détecter le faisceau laser composite se trouvent placées dans le plan (*xOz*) sur lequel leurs positions $P_n$ sont repérées en cordonnées polaires par la distance $d'_n$ entre le point $P_n$ et le point de référence *O* et par l'angle $\gamma'_n$ que forme le segment $OP_n$ avec l'axe de référence (*Ox*), comme l'illustre la figure 6.

La différence de marche $\delta_n$ est donc donnée, dans ce cas, par la relation suivante :

$$\delta_n = D'_n - D$$
$$= D\cdot\left(\sqrt{1 - 2(\cos\gamma'_n\cos\beta\cos\alpha + \sin\gamma'_n\sin\beta)\left(\frac{d'_n}{D}\right) + \left(\frac{d'_n}{D}\right)^2} - 1\right) [002]$$

Par suite, pour une loi de phase voulue $\{\Delta\varphi_n\}$, la loi de phase corrigée $\{\Delta\varphi'_n\}$ à émettre est donnée par la relation suivante :

$$\Delta\varphi'_n = \Delta\varphi_n - 2\pi f_s \frac{D}{c}\left(\sqrt{1 - 2(\cos\gamma'_n \cos\beta \cos\alpha + \sin\gamma'_n \sin\beta)\left(\frac{d'_n}{D}\right) + \left(\frac{d'_n}{D}\right)^2} - 1\right)$$

[003]

dans laquelle $D$, $\alpha$ et $\beta$ représentent les inconnues.

Afin de disposer de mesures de $D$, $\alpha$ et $\beta$, le module de mesure 44 réalise donc, pour au moins trois points non colinéaires $C_1$, $C_2$ et $C_3$ du plan ($xOz$) de la matrice de photodiodes 422, les mesures des distances $D_1$, $D_2$ et $D_3$, séparant ces points du point $M$ d'émission du faisceau laser composite 43.

Par suite, si ces points $C_n$ sont repérés dans le plan ($xOz$) par la distance $d_n$ et l'angle $\gamma_n$, comme l'illustre la figure 7, on montre que $D$, $\alpha$ et $\beta$ sont donnés par les relations suivantes :

$$D = \sqrt{\frac{d_2 d_3 (D_1{}^2 - d_1{}^2)[\cos\gamma_2 \sin(\gamma_1 - \gamma_3) - \cos\gamma_3 \sin(\gamma_1 - \gamma_2)]}{d_3(d_2 \cos\gamma_2 - d_1 \cos\gamma_1) \sin(\gamma_1 - \gamma_3) - d_2(d_3 \cos\gamma_3 - d_1 \cos\gamma_1) \sin(\gamma_1 - \gamma_2)} +}$$

$$\frac{d_1 \cos\gamma_1 [d_2(D_3{}^2 - d_3{}^2) \sin(\gamma_1 - \gamma_2) - d_3(D_2{}^2 - d_2{}^2) \sin(\gamma_1 - \gamma_3)]}{d_3(d_2 \cos\gamma_2 - d_1 \cos\gamma_1) \sin(\gamma_1 - \gamma_3) - d_2(d_3 \cos\gamma_3 - d_1 \cos\gamma_1) \sin(\gamma_1 - \gamma_2)}$$

[004]

$$\beta = \text{Arcsin}\,\frac{(d_1{}^2 + D^2 - D_1{}^2)d_2 \cos\gamma_2 - (d_2{}^2 + D^2 - D_2{}^2)d_1 \cos\gamma_1}{2 d_1 d_2 D \sin(\gamma_1 - \gamma_2)}$$

[005]

$$\alpha = \text{Arccos}\,\frac{\frac{d_1{}^2 + D^2 - D_1{}^2}{2 d_1 D} - \sin\gamma_1 \sin\beta}{\cos\gamma_1 \cos\beta}$$

[006]

Selon l'invention les distances $D_n$ peuvent ainsi être mesurées par tout moyen de mesure approprié connu de l'état de l'art, tel que par exemple des moyens de mesure par télémétrie laser tels que les distancemètres laser vendu dans le commerce et ayant des précisions de l'ordre du millimètre.

Cependant dans un mode de réalisation préféré de l'invention les mesures sont réalisées au moyen du faisceau laser composite 43, ce qui permet avantageusement de ne pas ajouter d'équipement particulier pour réaliser le module de mesure 44.

D'un point de vue matériel, il est à noter que les points $C_n$ choisis pour mesurer les distances $D_n$ peuvent être confondus avec des points $P_n$ sur lesquels sont positionnées des photodiodes. En effet, la matrice de photodiodes est pourvue au niveau des points $P_n$ de filtres laissant passer chacun une des longueurs d'ondes $\lambda_n$.

Or ces filtres peuvent avantageusement être des réflecteurs catadioptriques pour des longueurs d'ondes différentes de $\lambda_{n' \neq n}$ de sorte qu'il est toujours possible d'utiliser le faisceau laser composite pour réaliser les mesures des distances $D_n$.

Il est à noter que du fait que le dispositif selon l'invention comporte deux sous-ensembles complètement séparés et que la transmission de la loi de phase générée par le sous-ensemble générateur de signaux 41 est transmise au sous-ensemble d'émission 42 au moyen d'un faisceau laser composite pointé dans la direction de ce dernier à l'aide d'une optique de pointage 417, la structure de principe de l'invention telle qu'illustrée par la figure 4 peut être étendue à des structure mettant en œuvre deux ou plusieurs sous-ensembles d'émission agencés vis-à-vis du sous-ensemble Générateur de signaux 42.

En effet, l'optique pointée 417 du générateur de signaux 41 peut être configurée pour diriger un faisceau laser composite avec une orientation d'un panneau à l'autre de façon séquentielle, la loi d'amplitude-phase portée par le faisceau laser 43 pouvant être différente.

Ainsi un même Générateur de signaux 41 de loi d'amplitude-phase sur porteuse optique peut piloter plusieurs sous-ensembles d'émission 42 pour leur faire rayonner différents signaux dans différentes directions selon un séquencement approprié, les lois de phase associées à chacun des sous-ensembles d'émission faisant l'objet d'une correction particulière par le système de correction du dispositif.

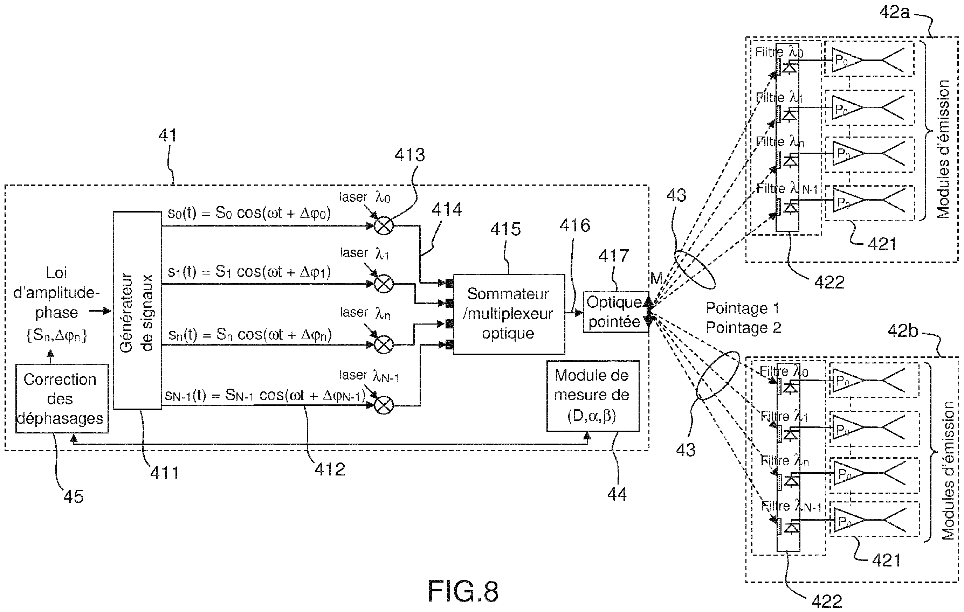

La figure 8 offre une représentation schématique d'un dispositif de stimulation radioélectrique par panneau rayonnant selon l'invention comportant deux sous-ensembles d'émission 42a et 42b.

Il est à noter que, contrairement à ce que peut, peut-être, laisser penser la représentation schématique fonctionnelle de la figure 4, la matrice de photodiodes avec filtres 422 n'occupe dans le contexte de la présente invention aucune position particulière vis-à-vis des modules d'émission 421. En particulier la matrice de photodiodes 422 ne se trouve pas nécessairement placée sur la face de la structure formée par les modules d'émission 421 opposée à la face rayonnante de cette dernière. Le positionnement relatif de la matrice de photodiode et des modules d'émission est plus généralement lié aux contraintes relatives à l'application considérée.

**Revendications**

1.  Dispositif de stimulation radioélectrique par panneau rayonnant, pour émettre un signal de test vers une antenne de réception, ledit dispositif comportant un sous-ensemble (41) générateur de signaux électriques d'excitation (412) présentant chacun une phase correspondant à une loi de phase souhaitée $\{\Delta\varphi_n\}$ et au moins un sous-ensemble d'émission (42) configuré pour amplifier et rayonner lesdits signaux électriques de façon à émettre un faisceau radioélectrique dans une direction déterminée par ladite loi de phase $\{\Delta\varphi_n\}$, les signaux électriques (412) étant transmis par le sous-ensemble générateur (41) vers le sous-ensemble d'émission (42) sous forme d'ondes laser (414) modulées par lesdits signaux et formant un faisceau laser composite (43) dirigé vers la surface d'un ensemble de photodétecteurs (422) intégré au sous-ensemble d'émission (42),

    **caractérisé en ce que**, le sous-ensemble générateur de signaux électriques (41) et le sous-ensemble d'émission (42) étant agencés l'un vis-à-vis de l'autre de telle façon que le faisceau laser composite (43) soit dirigé vers la surface de l'ensemble de photodétecteurs (422) sous une incidence $(\alpha, \beta)$ par rapport à un axe de référence et qu'il parcourt une distance $D$ entre son point d'émission $M$ et un point de référence $O$ situé sur l'axe de référence au niveau de la surface de l'ensemble de photodétecteurs, le dispositif comporte un système de correction (44, 45) configuré pour mesurer les valeurs $\alpha$, $\beta$ et $D$ et délivrer une loi de phase corrigée $\{\Delta\varphi'_n\}$ venant se substituer à la loi de phase voulue $\{\Delta\varphi_n\}$, la loi de phase corrigée étant définie de telle façon que le faisceau radioélectrique produit à partir des signaux générés par le module générateur de signaux (41) soit orienté dans la direction correspondant à la loi de phase voulue $\{\Delta\varphi_n\}$.

    la loi de phase corrigée $\{\Delta\varphi'_n\}$ étant déterminée à partir du calcul de la différence de marche $\delta_n = D'_n - D$ engendrée, au niveau de chacun des photodétecteurs (423), par l'angle d'incidence du faisceau laser composite (43) sur la surface de l'ensemble de photodétecteurs (422) du sous-ensemble d'émission (42), $\Delta\varphi'_n$ étant défini par la relation :

    $$\Delta\varphi'_n = \Delta\varphi_n - 2\pi\frac{f_s}{c}\cdot\delta_n \; ;$$

    $D'_n$ représentant la distance entre le point d'émission $M$ du faisceau laser composite et la position $P_n$ du photodétecteur considéré.

2.  Dispositif selon la revendication 1, **caractérisé en ce que** les photodétecteurs (423) qui forment l'ensemble de photodétecteurs (422) du sous-ensemble d'émission (42) étant agencés dans un plan ($xOz$) sur lequel leurs positions $P_n$ sont repérées, en cordonnées polaires, par une distance $d'_n$ et un angle $\gamma'_n$, la différence de marche $\delta_n$ est définie, pour chaque photodétecteur, par la relation suivante :

    $$\delta_n = D'_n - D$$
    $$= D\cdot\left(\sqrt{1 - 2(\cos\gamma'_n\cos\beta\cos\alpha + \sin\gamma'_n\sin\beta)\left(\frac{d'_n}{D}\right) + \left(\frac{d'_n}{D}\right)^2} - 1\right).$$

3.  Dispositif selon la revendication 2, **caractérisé en ce que** les valeurs $\alpha$, $\beta$ et $D$ sont déterminées en considérant une pluralité de points $C_n$, non alignés, situés à la surface de l'ensemble de photodétecteurs (422), et en déterminant la distance $D_n$ séparant le point $M$ d'émission du faisceau laser composite (43) de chacun des points $C_n$ considérés.

4. Dispositif selon la revendication 3, **caractérisé en ce que** l'on considère au moins trois points non alignés.

5. Dispositif selon la revendication 4, **caractérisé en ce que**, les points $C_n$ étant repérés dans le plan ($xOz$) par leur distance $d_n$ au point de référence $O$ et par l'angle $\gamma_n$ entre l'axe reliant le point $C_n$ considéré au point $O$ et l'axe de référence ($Ox$), $D$, $\alpha$ et $\beta$ sont donnés par les relations suivantes :

$$D = \sqrt{\frac{d_2 d_3 \left(D_1{}^2 - d_1{}^2\right)\left[\cos\gamma_2 \sin(\gamma_1 - \gamma_3) - \cos\gamma_3 \sin(\gamma_1 - \gamma_2)\right]}{d_3(d_2\cos\gamma_2 - d_1\cos\gamma_1)\sin(\gamma_1 - \gamma_3) - d_2(d_3\cos\gamma_3 - d_1\cos\gamma_1)\sin(\gamma_1 - \gamma_2)} + \frac{d_1\cos\gamma_1\left[d_2\left(D_3{}^2 - d_3{}^2\right)\sin(\gamma_1 - \gamma_2) - d_3\left(D_2{}^2 - d_2{}^2\right)\sin(\gamma_1 - \gamma_3)\right]}{d_3(d_2\cos\gamma_2 - d_1\cos\gamma_1)\sin(\gamma_1 - \gamma_3) - d_2(d_3\cos\gamma_3 - d_1\cos\gamma_1)\sin(\gamma_1 - \gamma_2)}} \ ;$$

$$\beta = \text{Arcsin}\,\frac{\left(d_1{}^2 + D^2 - D_1{}^2\right)d_2\cos\gamma_2 - \left(d_2{}^2 + D^2 - D_2{}^2\right)d_1\cos\gamma_1}{2 d_1 d_2 D \sin(\gamma_1 - \gamma_2)}$$

et

$$\alpha = \text{Arccos}\,\frac{\frac{d_1{}^2 + D^2 - D_1{}^2}{2 d_1 D} - \sin\gamma_1 \sin\beta}{\cos\gamma_1 \cos\beta}.$$

6. Dispositif selon l'une des revendications 3 à 5, **caractérisé en ce que** les distances $D_n$ sont mesurées par télémétrie laser.

7. Dispositif selon l'une des revendications 3 à 5, **caractérisé en ce que** les distances $D_n$ sont mesurées en utilisant le faisceau laser composite (43) produit par le sous-ensemble générateur de signaux (41).

8. Dispositif selon l'une quelconque des revendications précédentes, **caractérisé en ce que** l'ensemble de photodétecteurs est constitué par une matrice de photodiodes (423) associées chacune à un filtre optique (424) configuré pour ne permettre l'exposition de la photodiode considérée qu'à une des ondes laser modulées (414) formant le faisceau laser composite (43).

9. Dispositif selon l'une quelconque des revendications précédentes, **caractérisé en ce qu'**il comporte un sous-ensemble générateur de signaux électriques (41) et au moins deux sous-ensembles d'émission (42a, 42b), une optique pointée (417) étant configurée pour diriger le faisceau laser composite alternativement sur l'un ou l'autre des sous-ensembles d'émission (42a, 42b), le système de correction de la loi de phase étant configuré pour délivrer à chaque moment la loi de phase corrigée $\{\Delta\varphi_n'\}$ correspondant au sous-ensemble (42a, 42b) sur lequel le faisceau laser composite (43) est dirigé à l'instant considéré.

## Patentansprüche

1. Strahlungsfeld-Funkstimulationsvorrichtung zum Aussenden eines Testsignals an eine Empfangsantenne, wobei die Vorrichtung eine Generator-Teilgruppe (41) von elektrischen Anregungssignalen (412) umfasst, welche jeweils eine Phase aufweisen, welche einem gewünschten Phasengesetz $\{\Delta\varphi_n\}$ entspricht und mindestens eine Sende-Teilgruppe (42), welche konfiguriert ist, um die elektrischen Signale zu verstärken und auszustrahlen, um einen Funkstrahl in eine durch das Phasengesetz $\{\Delta\varphi_n\}$ bestimmte Richtung zu senden, wobei die elektrischen Signale (412) durch die Generator-Teilgruppe (41) an die Sende-Teilgruppe (42) in Form von Laserwellen (414) übertragen werden, welche durch die Signale moduliert werden und einen Verbund-Laserstrahl (43) bilden, welcher auf die Oberfläche einer Gruppe von Photodetektoren (422) gerichtet ist, welche in die Sende-Teilgruppe (42) integriert ist,

**dadurch gekennzeichnet dass**, da die Generator-Teilgruppe von elektrischen Signalen (41) und die Sende-Teilgruppe (42) in Bezug auf einander dergestalt angeordnet sind, dass der Verbund-Laserstrahl (43) auf die Oberfläche der Gruppe von Photodetektoren (422) mit einem Einfallwinkel {$\alpha, \beta$} in Bezug auf eine Bezugsachse gerichtet ist, und eine Strecke *D* zwischen seinem Aussendepunkt M und einem Bezugspunkt *O* zurückgelegt, welcher auf der Bezugsachse auf Höhe der Oberfläche der Gruppe von Photodetektoren befindlich ist, die Vorrichtung ein Korrektursystem (44, 45) umfasst, welches konfiguriert ist, um die Werte $\alpha$, $\beta$ und *D* zu messen und ein korrigiertes Phasengesetz

$$\{\Delta\varphi'_n\}$$

abzugeben, welches anstelle des gewünschten Phasengesetzes $\{\Delta\varphi_n\}$ tritt, wobei das korrigierte Phasengesetz dergestalt definiert ist, dass der anhand der durch das Signal-Generatormodul (41) generierten Signale erzeugte Funkstrahl in die Richtung gerichtet wird, welche dem gewünschten Phasengesetz $\{\Delta\varphi_n\}$ entspricht, wobei, da das korrigierte Phasengesetz

$$\{\Delta\varphi'_n\}$$

anhand der Berechnung der Gangdifferenz

$$\delta_n = D'_n - D$$

bestimmt wird, auf Höhe eines jeden der Photodetektoren (423), welche durch den Einfallwinkel des Verbund-Laserstrahls (43) auf der Oberfläche der Gruppe von Photodetektoren (422) der Sende-Teilgruppe (42) erzeugt wird, wobei

$$\Delta\varphi'_n$$

durch folgende Beziehung definiert wird :

$$\Delta\varphi'_n = \Delta\varphi_n - 2\pi\frac{f_s}{c}\cdot\delta_n;$$

wobei

$$D'_n$$

den Abstand zwischen dem Aussendepunkt *M* des Verbund-Laserstrahls und der Position $P_n$ des betrachteten Photodetektors darstellt.

2. Vorrichtung nach Anspruch 1, **dadurch gekennzeichnet, dass** die Photodetektoren (423), welche die Gruppe von Photodetektoren (422) der Sende-Teilgruppe (42) bilden, in einer Ebene *(xOz)* angeordnet sind, auf welcher ihre Positionen $P_n$ in polaren Koordinaten durch einen Abstand

$$d'_n$$

und einen Winkel

$$\gamma'_n$$

markiert sind, wobei die Gangdifferenz $\delta_n$ für jeden Photodetektor durch folgende Beziehung definiert ist:

$$\delta_n = D_n' - D$$

$$= D \cdot \left( \sqrt{1 - 2(\cos\gamma_n' \cos\beta \cos\alpha + \sin\gamma_n' \sin\beta)\left(\frac{d_n'}{D}\right) + \left(\frac{d_n'}{D}\right)^2} - 1 \right).$$

$$= D \cdot \left( \sqrt{1 - 2(\cos\gamma_n' \cos\beta \cos\alpha + \sin\gamma_n' \sin\beta)\left(\frac{d_n'}{D}\right) + \left(\frac{d_n'}{D}\right)^2} - 1 \right)$$

3. Vorrichtung nach Anspruch 2, **dadurch gekennzeichnet, dass** die Werte $\alpha$, $\beta$ und D unter Betrachtung einer Vielzahl von nicht ausgefluchteten Punkten $C_n$ bestimmt werden, welche an der Oberfläche der Gruppe von Photodetektoren (422) befindlich sind, und unter Bestimmung des Abstandes $D_n$, welcher den Aussendepunkt $M$ des Verbund-Laserstrahls (43) von einem jeden der betrachteten Punkte $C_n$ trennt.

4. Vorrichtung nach Anspruch 3, **dadurch gekennzeichnet, dass** man mindestens drei nicht ausgefluchtete Punkte betrachtet.

5. Vorrichtung nach Anspruch 4, **dadurch gekennzeichnet, dass**, da die Punkte $C_n$ in der Ebene (*xOz*) durch ihren Abstand $d_n$ zum Bezugspunkt $O$ und durch den Winkel $\gamma_n$ zwischen der Achse, welche den betrachteten Punkt $C_n$ mit dem Punkt $O$ und der Bezugsachse (*Ox*) verbindet, markiert sind, $D$, $\alpha$ und $\beta$ sich aus folgenden Beziehungen ergeben:

$$D = \sqrt{\frac{d_2 d_3 \left(D_1^2 - d_1^2\right)[\cos\gamma_2 \sin(\gamma_1 - \gamma_3) - \cos\gamma_3 \sin(\gamma_1 - \gamma_2)]}{d_3(d_2 \cos\gamma_2 - d_1 \cos\gamma_1)\sin(\gamma_1 - \gamma_3) - d_2(d_3 \cos\gamma_3 - d_1 \cos\gamma_1)\sin(\gamma_1 - \gamma_2)} + }$$

$$\overline{\frac{d_1 \cos\gamma_1[d_2\left(D_3^2 - d_3^2\right)\sin(\gamma_1 - \gamma_2) - d_3\left(D_2^2 - d_2^2\right)\sin(\gamma_1 - \gamma_3)]}{d_3(d_2 \cos\gamma_2 - d_1 \cos\gamma_1)\sin(\gamma_1 - \gamma_3) - d_2(d_3 \cos\gamma_3 - d_1 \cos\gamma_1)\sin(\gamma_1 - \gamma_2)}} \; ;$$

$$\beta = \operatorname{Arcsin} \frac{\left(d_1^2 + D^2 - D_1^2\right)d_2 \cos\gamma_2 - \left(d_2^2 + D^2 - D_2^2\right)d_1 \cos\gamma_1}{2 d_1 d_2 D \sin(\gamma_1 - \gamma_2)}$$

und

$$\alpha = \operatorname{Arccos} \frac{\frac{d_1^2 + D^2 - D_1^2}{2 d_1 D} - \sin\gamma_1 \sin\beta}{\cos\gamma_1 \cos\beta}.$$

6. Vorrichtung nach einem der Ansprüche 3 bis 5, **dadurch gekennzeichnet, dass** die Abstände $D_n$ mittels Laser-Telemetrie gemessen werden.

7. Vorrichtung nach einem der Ansprüche 3 bis 5, **dadurch gekennzeichnet, dass** die Abstände $D_n$ unter Verwendung des Verbund-Laserstrahls (43) gemessen werden, welcher durch die Generator-Teilgruppe von Signalen (41) erzeugt wird.

8. Vorrichtung nach einem der vorhergehenden Ansprüche, **dadurch gekennzeichnet, dass** die Gruppe von Photodetektoren aus einer Matrix von Photodioden (423) gebildet ist, welche jeweils einem optischen Filter (424) zugeordnet sind, welcher konfiguriert ist, um die Exposition der betrachteten Photodiode nur gegenüber einer der modulierten Laserwellen (414) zu ermöglichen, welche den Verbund-Laserstrahl (43) bilden.

9. Vorrichtung nach einem der vorhergehenden Ansprüche, **dadurch gekennzeichnet, dass** sie eine Generator-Teilgruppe von elektrischen Signalen (41) und mindestens zwei Sender-Teilgruppen (42a, 42b) umfasst, wobei eine gerichtete Optik (417) konfiguriert ist, um den Verbund-Laserstrahl alternativ auf die eine oder die andere Sende-Teilgruppe (42a, 42b) zu richten, wobei das Korrektursystem des Phasengesetzes konfiguriert ist, um zu jedem Zeitpunkt das korrigierte Phasengesetz

$$\{\Delta\varphi_n'\}$$

abzugeben, welches der Teilgruppe (42a, 42b) entspricht, auf welche der Verbund-Laserstrahl (43) zum betrachteten Zeitpunkt gerichtet ist.

**Claims**

1. A radiant panel radio stimulation device, for emitting a test signal to a reception antenna, said device comprising a subassembly (41) generating excitation electrical signals (412) each having a phase corresponding to a desired phase law $\{\Delta\varphi_n\}$ and at least one emission subassembly (42) configured to amplify and radiate said electrical signals so as to emit a radio beam in a direction determined by said phase law $\{\Delta\varphi_n\}$, the electrical signals (412) being transmitted by the generating subassembly (41) to the emission subassembly (42) in the form of laser waves (414) modulated by said signals and forming a composite laser beam (43) directed toward the surface of a set of photodetectors (422) incorporated in the emission subassembly (42),

   **characterised in that**, the electrical signal generator subassembly (41) and the emission subassembly (42) being arranged with respect to each other so that the composite laser beam (43) is directed toward the surface of the set of photodetectors (422) with an incidence ($\alpha$, $\beta$) relative to a reference axis and that it travels a distance $D$ between its point of emission $M$ and a reference point $O$ situated on the reference axis at the surface of the set of photodetectors, the device comprises a correction system (44, 45) configured to measure the values $\alpha$, $\beta$ and $D$ and deliver a corrected phase law $\{\Delta\varphi_n'\}$ that is substituted for the desired phase law $\{\Delta\varphi_n\}$, the corrected phase law being defined in such a way that the radio beam produced from the signals generated by the signal generator module (41) is oriented in the direction corresponding to the desired phase law $\{\Delta\varphi_n\}$,

   the corrected phase law $\{\Delta\varphi_n'\}$ being determined from the calculation of the path-length difference $\delta_n = D_n' - D$ generated, at each of the photodetectors (423), by the angle of incidence of the composite laser beam (43) on the surface of the set of photodetectors (422) of the emission subassembly (42), $\Delta\varphi_n'$ being defined by the relationship:

$$\Delta\varphi_n' = \Delta\varphi_n - 2\pi\frac{f_s}{c}\cdot\delta_n \;;$$

   $D_n'$ representing the distance between the point of emission $M$ of the composite laser beam and the position $P_n$ of the photodetector considered.

2. The device according to claim 1, **characterised in that**, the photodetectors (423) which form the set of photodetectors (422) of the emission subassembly (42) being arranged in a plane ($xOz$) on which their positions $P_n$ are registered, in terms of polar coordinates, by a distance $d_n'$ and an angle $\gamma_n'$, the path-length difference $\delta_n$ is defined, for each photodetector, by the following relationship:

$$\delta_n = D'_n - D$$
$$= D \cdot \left( \sqrt{1 - 2(\cos\gamma'_n \cos\beta \cos\alpha + \sin\gamma'_n \sin\beta)\left(\frac{d'_n}{D}\right) + \left(\frac{d'_n}{D}\right)^2} - 1 \right).$$

3. The device according to claim 2, **characterised in that** the values $\alpha$, $\beta$ and $D$ are determined by considering a plurality of non-aligned points $C_n$, situated on the surface of the set of photodetectors (422), and by determining the distance $D_n$ separating the point M of emission of the composite laser beam (43) from each of the points $C_n$ considered.

4. The device according to claim 3, **characterised in that** at least three non-aligned points are considered.

5. The device according to claim 4, **characterised in that**, the points $C_n$ being registered in the plane (*xOz*) by their distance $d_n$ to the reference point $O$ and by the angle $\gamma_n$ between the axis linking the point $C_n$ considered to the point $O$ and the reference axis (*Ox*), $D$, $\alpha$ and $\beta$ are given by the following relationships:

$$D = \sqrt{\frac{\frac{d_2 d_3 \left(D_1{}^2 - d_1{}^2\right)[\cos\gamma_2 \sin(\gamma_1 - \gamma_3) - \cos\gamma_3 \sin(\gamma_1 - \gamma_2)]}{d_3(d_2 \cos\gamma_2 - d_1 \cos\gamma_1)\sin(\gamma_1 - \gamma_3) - d_2(d_3 \cos\gamma_3 - d_1 \cos\gamma_1)\sin(\gamma_1 - \gamma_2)} + \frac{d_1 \cos\gamma_1 [d_2\left(D_3{}^2 - d_3{}^2\right)\sin(\gamma_1 - \gamma_2) - d_3\left(D_2{}^2 - d_2{}^2\right)\sin(\gamma_1 - \gamma_3)]}{d_3(d_2 \cos\gamma_2 - d_1 \cos\gamma_1)\sin(\gamma_1 - \gamma_3) - d_2(d_3 \cos\gamma_3 - d_1 \cos\gamma_1)\sin(\gamma_1 - \gamma_2)}}} \; ;$$

$$\beta = \text{Arcsin}\,\frac{\left(d_1{}^2 + D^2 - D_1{}^2\right)d_2 \cos\gamma_2 - \left(d_2{}^2 + D^2 - D_2{}^2\right)d_1 \cos\gamma_1}{2 d_1 d_2 D \sin(\gamma_1 - \gamma_2)}$$

and

$$\alpha = \text{Arccos}\,\frac{\frac{d_1{}^2 + D^2 - D_1{}^2}{2 d_1 D} - \sin\gamma_1 \sin\beta}{\cos\gamma_1 \cos\beta}.$$

6. The device according to one of claims 3 to 5, **characterised in that** the distances $D_n$ are measured by laser rangefinding.

7. The device according to one of claims 3 to 5, **characterised in that** the distances $D_n$ are measured by using the composite laser beam (43) produced by the signal generator subassembly (41).

8. The device according to any one of the preceding claims, **characterised in that** the set of photodetectors consists of a matrix of photodiodes (423) each associated with an optical filter (424) configured to allow the exposure of the photodiode considered only to one of the modulated laser waves (414) forming the composite laser beam (43).

9. The device according to any one of the preceding claims, **characterised in that** it comprises an electrical signal generator subassembly (41) and at least two emission subassemblies (42a, 42b), an aimed optic (417) being configured to direct the composite laser beam alternately to one or other of the emission subassemblies (42a, 42b), the phase law correction system being configured to deliver, at each moment, the corrected phase law $\{\Delta\varphi'_n\}$ corresponding to the subassembly (42a, 42b) to which the composite laser beam (43) is directed at the instant considered.

$s(t) = S \cos \omega t$

$s_0(t) = S \cos(\omega t + \Delta\varphi_0)$

$s_1(t) = S \cos(\omega t + \Delta\varphi_1)$

$s_n(t) = S \cos(\omega t + \Delta\varphi_n)$

$s_{N-1}(t) = S \cos(\omega t + \Delta\varphi_{N-1})$

FIG.1

$s_0(t) = S_0 \cos(\omega t + \Delta\varphi_0)$

$s_1(t) = S_1 \cos(\omega t + \Delta\varphi_1)$

$s_n(t) = S_n \cos(\omega t + \Delta\varphi_n)$

$s_{N-1}(t) = S_{N-1} \cos(\omega t + \Delta\varphi_{N-1})$

FIG.2

Sous-ensemble de
génération de signaux

33

Sous-ensemble
d'émission

Générateur
de signaux

$s_0(t) = S_0 \cos(\omega t + \Delta\varphi_0)$

laser

$s_1(t) = S_1 \cos(\omega t + \Delta\varphi_1)$

laser

312

$s_n(t) = S_n \cos(\omega t + \Delta\varphi_n)$

laser

$s_{N-1}(t) = S_{N-1} \cos(\omega t + \Delta\varphi_{N-1})$

laser

$P_0$

$P_0$

$P_0$

$P_0$

Modules d'émission

Loi
d'amplitude-
phase
$\{S_n, \Delta\varphi_n\}$

31

311

Déport optique

321

32

FIG.3

Modules d'émission

425 421 423 422

$P_0$ $P_0$ $P_0$ $P_0$

$(D,\alpha,\beta)$

42 43 424

M

Optique pointée 417

416 Sommateur /multiplexeur optique 415

Module de mesure de $(D,\alpha,\beta)$ 44

laser $\lambda_0$ 413
laser $\lambda_1$ 414
laser $\lambda_n$
laser $\lambda_{N-1}$

$s_0(t)$
$s_1(t)$
$s_n(t)$
$s_{N-1}(t)$ 412

Générateur de signaux 411

Loi d'amplitude-phase $\{S_n, \Delta\varphi_n\}$

Correction des déphasages 45

41

FIG.4

FIG.5

FIG.6

FIG.7

FIG.8

**EP 3 707 528 B1**

## RÉFÉRENCES CITÉES DANS LA DESCRIPTION

**Documents brevets cités dans la description**

- FR 1700081

- WO 2015028091 A